# EUROPÄISCHE PATENTANMELDUNG

(11) **EP 0 942 272 A2**
(43) Veröffentlichungstag der Anmeldung: **15.09.1999**
(21) Anmeldenummer: 99103828.2
(22) Anmeldetag: 27.02.1999
(51) Int. Cl.: G01L 9/00, G01L 9/06, G01L 1/18

(54) **Sensoranordnung zur Messung von Druck, Kraft oder Messgrössen, die sich auf Druck oder Kraft zurückführen lassen, Verfahren zur Herstellung der Sensoranordnung, Sensorelement und Verfahren zur Herstellung des Sensorelements**

(30) Priorität: 12.03.1998 DE 19810756
(71) Anmelder: FRAUNHOFER-GESELLSCHAFT ZUR FÖRDERUNG DER ANGEWANDTEN FORSCHUNG E.V., 80636 München (DE)
(72) Erfinder: Faul, Robert, 80639 München (DE)

(57) **Zusammenfassung**

Die vorliegende Erfindung betrifft eine Sensoranordnung zur Messung von Druck, Kraft oder Meßgrößen, die sich auf Druck oder Kraft zurückführen lassen, ein Verfahren zur Herstellung einer solchen Sensoranordnung sowie ein Sensorelement und ein Verfahren zur Herstellung eines Sensorelements.

Die erfindungsgemäße Sensoranordnung umfaßt einen Chip (1) auf Si-Basis mit sensorischen Wandlergebieten und einer ersten Vorder- und einer ersten Rückseite, der auf mindestens der ersten Rückseite eine strukturierte Oberfläche mit Dünnungsgebieten (3) aufweist, wobei die strukturierte Oberfläche auf der ersten Rückseite eine intensivere Tiefenprofilierung als die erste Vorderseite aufweist, und ein Trägersubstrat (2) mit einer zweiten Vorder- und einer zweiten Rückseite, wobei die zweite Vorderseite glatt und weitgehend fugenlos ist und der Chip und das Trägersubstrat dergestalt zusammengefügt sind, daß die erste und die zweite Rückseite aneinandergrenzen.

Durch die vorliegende Erfindung wird somit eine weitgehend flache Sensoranordnung mit möglichst wenig Fugen bzw. Vertiefungen bereitgestellt.

Weitere Vorteile der vorliegenden Erfindung betreffen die Möglichkeit einer rationellen und kostengünstigen Herstellung der Sensoranordnung durch eine Full-Wafer-Verbindungstechnik sowie die Möglichkeit, mit der erfindungsgemäßen Sensoranordnung sehr hohe Drücke zu messen.

Die erfindungsgemäße Vorrichtung kann vorteilhafterweise in der Lebensmittelbranche angewendet werden, wenn aus hygienischen Gründen der Kontakt von Lebensmitteln mit Fugen bzw. Absätzen vermieden werden soll.

## Beschreibung

Die vorliegende Erfindung betrifft eine Sensoranordnung zur Messung von Druck, Kraft oder Meßgrößen, die sich auf Druck oder Kraft zurückführen lassen, mit den Merkmalen des Oberbegriffs von Anspruch 1, ein Verfahren zur Herstellung einer solchen Sensoranordnung mit den Merkmalen des Oberbegriffs von Anspruch 20 sowie ein Sensorelement und ein Verfahren zur Herstellung eines Sensorelements.

Bei herkömmlichen Drucksensoren basieren die Meßbasis und damit das Wandlerelement auf der Siliziumtechnologie, und diese sind mikromechanisch bearbeitet. Es ist dabei ein bekanntes Vorgehen, daß man mit Hilfe von Ätztechnologien in Silizium Dünnungsgebiete erzeugt. In diesen Dünnungsgebieten tritt bei mechanischer Belastung des Bauelements durch beispielsweise einen Druck gebündelt eine Mikrodeformation auf, die beispielsweise von ebenfalls gut bekannten piezoresistiven Elementen in elektrisch verarbeitbare Signale gewandelt werden.

Bei derartigen Anordnungen ist der mikromechanische Chip auf einen Träger montiert. Vom Chip zum Träger verlaufen Bonddrähte, so daß der resultierende Aufbau ein nichtplanares Oberflächenrelief darstellt.

Für einige Anwendungen, beispielsweise speziell in der Lebensmittelbranche, wird besonders darauf Wert gelegt, daß entlang der gesamten Oberfläche, mit der Lebensmittel in Berührung kommen, Fugen bzw. Absätze vermieden werden, weil an solchen Fugen und Absätzen eine Reinigung der Anlage erschwert ist. Folglich liegt ein nicht tolerierbares Risiko für eine Verkeimung vor.

Gefordert sind also beispielsweise Drucksensoren mit einer glatten Oberfläche. Solche Sensoren sind prinzipiell bekannt und am Markt erhältlich, beispielsweise bei Baumer electric, CH-8500 Frauenfeld. Bei derartigen bekannten Sensoren wird häufig eine sogenannte Medientrennmembran, beispielsweise aus Stahl, verwendet, die eine geeignet glatte Oberfläche aufweisen. Der eigentliche Sensor wird gegenüber der Membran also abgewandet vom zu messenden Medium angeordnet. Die Drucktransmission von der Trennmembran zum Sensor-Dünnungsgebiet wird durch eine Flüssigkeitsfüllung des Zwischenraums und somit hydraulisch hergestellt. Diese Konstruktion führt jedoch nicht durchwegs zu sonderlich flachen Bauformen der Sensoren.

Alternativ kann, um den hohen Reinheitsvorschriften zu genügen, auch die Kontaktierung des Chips an den Träger über Bonddrähte dahingehend verbessert werden, daß der Sensorchip in Flip-Chip-Montage auf einem Träger aufgebaut wird, wodurch die Bonddrähte vermieden werden und somit das Oberflächenrelief verringert wird. Nachteilig bei diesem Lösungsweg ist jedoch, daß als Konsequenz der Flip-Chip-Montage die mikromechanisch bearbeitete Rückseite des Chips zu einer spezifischen Art von Oberflächenunebenheit beiträgt. Genauer gesagt, werden durch die Flip-Chip-Montage neue Fugen bzw. Vertiefungen erzeugt, wodurch den Forderungen nach einer weitestgehend glatten Oberfläche nicht genüge getan wird.

Ein Drucksensor mit den Merkmalen des Oberbegriffs von Patentanspruch 1 bzw. ein Verfahren mit den Merkmalen des Oberbegriffs von Patentanspruch 20, bei dem das Problem der Oberflächenunebenheiten teilweise gelöst zu sein scheint, ist aus der Patentschrift DD 291 398 bekannt. Der aus dieser Druckschrift bekannte Drucksensor weist zwei Druckmembranen für unterschiedliche Nenndrücke auf, die sich jeweils auf einer Ebene und gemeinsam in einem ersten Teilkörper des Drucksensors befinden. Dabei enthält die Druckmembran für den niedrigen Nenndruck einen verformungssteifen Rahmen, dieser Rahmen enthält im Inneren eine zweite, ebene Druckmembran für einen größeren Nenndruckwert, der dem Nenndruckbereich des Sensors entspricht, und die Auslenkung des verformungssteifen Rahmens wird bei Drücken, die gleich oder größer dem Nenndruckwert der Druckmembran für den kleineren Druckbereich sind, durch einen mit dem Drucksensorchip verbundenen Gegenkörper begrenzt. Beide Druckmembranen enthalten jeweils eine piezoresistive Widerstandsstruktur, die im jeweiligen Nenndruckbereich ein druckabhängiges elektrisches Ausgangssignal, im allgemeinen eine Ausgangsspannung liefern.

Nachteilig ist bei diesem Drucksensor jedoch, daß sich die piezoresistiven Wandlergebiete auf dem Oberflächenbereich des Sensors befinden, der dem zu messenden Druck ausgesetzt ist. Genauer gesagt, treten bei der Kontaktierung des Drucksensors über Bonddrähte wieder die vorstehend erwähnten Probleme auf, da eine Einleitung des zu messenden Drucks nicht von der Seite her möglich ist, die von den piezoresistiven Wandlergebieten abgewandt ist.

Der vorliegenden Erfindung liegt somit die Aufgabe zugrunde, eine möglichst flache Sensoranordnung mit möglichst wenig Fugen bzw. Vertiefungen auf der Seite, auf der die Meßgröße eingeleitet wird, bereitzustellen, bei der insbesondere eine Einleitung der Meßgröße von der Seite der Sensoranordnung, die vom sensorischen Wandlergebiet abgewandt ist, her möglich ist. Ferner liegt der vorliegenden Erfindung die Aufgabe zugrunde, ein Verfahren zur Herstellung einer solchen Sensoranordnung bereitzustellen.

Gemäß der vorliegenden Erfindung wird die Aufgabe durch die kennzeichnenden Merkmale der Ansprüche 1 und 20 gelöst. Die vorliegende Erfindung stellt darüber hinaus auch das Sensorelement nach Anspruch 16 sowie das Verfahren zur Herstellung eines Sensorelements nach Anspruch 36 bereit.

Die bevorzugten Ausführungsformen sind Gegenstand der abhängigen Ansprüche.

Die vorliegende Erfindung schafft somit eine Sensoranordnung zur Messung von Druck, Kraft oder Meßgrößen, die sich auf Druck oder Kraft zurückführen lassen, mit einem Chip auf Si-Basis mit mindestens einem sensorischen Wandlergebiet und einer ersten Vorder- und einer ersten Rückseite, der auf mindestens der ersten Rückseite eine strukturierte Oberfläche mit mindestens einem Dünnungsgebiet, das umlaufend ein Versteifungsgebiet umschließt, aufweist, wobei die strukturierte Oberfläche auf der ersten Rückseite eine intensivere Tiefenprofilierung als die erste Vorderseite aufweist, einem Trägersubstrat mit einer zweiten Vorder- und einer zweiten Rückseite, wobei die zweite Vorderseite glatt und weitgehend fugenlos ist und der Chip und das Trägersubstrat dergestalt zusammengefügt sind, daß die erste und die zweite Rückseite aneinandergrenzen, wobei die Sensoranordnung geeignet ist, eine Einleitung der Meßgröße auf die zweite Vorderseite zuzulassen, das mindestens eine Dünnungsgebiet der ersten Rückseite eine vorbestimmte Dünnungstiefe aufweist und die erste und zweite Rückseite in allen Teilgebieten der Sensoranordnung außer den Bereichen der Dünnungsgebiete lückenlos aneinandergrenzen oder feste Verbindungsbereiche aufweisen.

Darüber hinaus schafft die vorliegende Erfindung ein Verfahren zur Herstellung einer Sensoranordnung zur Messung von Druck, Kraft oder Meßgrößen, die sich auf Druck oder Kraft zurückführen lassen, mit den Schritten zum Bereitstellen eines Chips auf Si-Basis mit mindestens einem sensorischen Wandlergebiet und einer ersten Vorderund einer ersten Rückseite, mikromechanischen Strukturieren von mindestens der ersten Rückseite, so daß mindestens ein Dünnungsgebiet, das umlaufend ein Versteifungsgebiet umschließt, erzeugt wird, wobei die Strukturierung derart erfolgt, daß die strukturierte Oberfläche auf der ersten Rückseite eine intensivere Tiefenprofllierung als die erste Vorderseite aufweist, Bereitstellen eines Trägersubstrats mit einer zweiten Vorder- und einer zweiten Rückseite, bei dem die zweite Vorderseite glatt und weitgehend fugenlos ist, und Zusammenfügen des Chips und des Trägersubstrats dergestalt, daß die erste und die zweite Rückseite aneinandergrenzen, wobei das mindestens eine Dünnungsgebiet der ersten Rückseite eine vorbestimmte Dünnungstiefe aufweist und die erste und zweite Rückseite in allen Teilgebieten der Sensoranordnung außer den Bereichen der Dünnungsgebiete lückenlos aneinandergrenzen oder feste Verbindungsbereiche aufweisen.

Die vorliegende Erfindung betrifft darüber hinaus ein Sensorelement mit einer Sensoranordnung wie vorstehend definiert und einem Montagekörper, in den die Sensoranordnung weitgehend oberflächenbündig eingesetzt ist, sowie ein Verfahren zur Herstellung eines Sensorelements mit den Schritten zum Bereitstellen einer Sensoranordnung wie vorstehend definiert und weitgehend oberflächenbündigen Einsetzen der Sensoranordnung in einen Montagekörper.

Aufgrund der speziellen Ausgestaltung der erfindungsgemäßen Sensoranordnung, bei der die erste und zweite Rückseite in allen Teilgebieten der Sensoranordnung außer den Bereichen der Dünnungsgebiete lückenlos aneinandergrenzen oder feste Verbindungsbereiche aufweisen, ist eine Einleitung der Meßgröße auch von der Seite der Sensoranordnung, die von den sensorischen Wandlergebieten abgewandt ist, her möglich. Genauer gesagt, kann aufgrund dieser Ausgestaltung ein auf das möglicherweise unstrukturierte Trägersubstrat eingeleiteter Druck dennoch zuverlässig in dem sensorischen Wandlergebiet des Chips nachgewiesen werden. Dabei kann die erfindungsgemäße Sensoranordnung selbstverständlich auch verwendet werden, indem die Einleitung der Meßgröße von der Seite her erfolgt, auf der das sensorische Wandlergebiet angeordnet ist, also von der Seite des Chips.

Durch die vorliegende Erfindung werden die folgenden Vorteile bereitgestellt:
- es wird eine fugenoptimierte Oberfläche bereitgestellt, bei der Vertiefungen, Absätze oder Unebenheiten als Folge der Kontaktierung mit Bonddrähten weitestgehend vermieden werden. Desweiteren kann beim Einsetzen der Sensoranordnung in den Montagekörper die Fuge zwischen Sensoranordnung und Montagekörper mit beispielsweise einem Kleber so gefüllt werden, daß sich wiederum de facto eine glatte Oberfläche ergibt. Da das Sensorelement bzw. die Sensoranordnung von der vom zu messenden Medium abgewandten Seite kontaktierbar ist, wird die glatte Oberfläche nicht durch das Vorhandensein von beispielsweise Bonddrähten bzw. Bonddrahtvergußmaterial gestört;
- es wird eine besonders flache Bauweise realisiert. Insbesondere entspricht die Gesamtdicke der Sensoranordnung weitestgehend nur der Summe der Dicken der verwendeten Wafer und/oder Substrate. Somit lassen sich Sensorbauhöhen bis herunter zu etwa 1 mm realisieren;
- die Herstellung der erfindungsgemäßen Sensoranordnung kann vereinfacht werden und damit rationeller und kostengünstiger erfolgen, wenn Chip und Trägersubstrat nicht in Einzelmontage Chip für Chip montiert werden müssen sondern im sogenannten Batchverfahren auf Waferebene zusammengefügt werden können. Das heißt, es ist im Unterschied zu den zum Teil sehr aufwendigen und damit teuren Montage- und Anordnungsverfahren mit Medientrennungsmembran oder mechanischen Übertragungsstößeln des Stands der Technik möglich, eine Vielzahl von Sensoranordnungen in einem einzigen Verfahrensmodul gleichzeitig bzw. parallel herzustellen;
- mit der erfindungsgemäßen Sensoranordnung ergeben sich darüber hinaus Vorteile beim Messen hoher Drücke. Das liegt daran, daß die mechanischen Kräfte in den Dünnungsgebieten, die sich infolge des Meßdrucks ergeben, auf die jeweiligen Dünnungsgebiete aufgeteilt werden, wobei sich das Aufteilungsverhältnis abhängig vom Verhältnis der Membrandicke des Chips zur Membrandicke des Trägersubstrats verhält; insbesondere kann dieses Verhältnis ohne großen technologischen Aufwand vorteilhaft auf den je nach Applikation zu messenden Druck hin variiert bzw. angepaßt werden;
- aufgrund der fugenlosen zweiten Vorderseite des Trägersubstrats kann die erfindungsgemäße Sensoranordnung auch in Bereichen eingesetzt werden, in denen eine starke Verdreckungsgefahr der Sensoranordnung besteht, beispielsweise im Feldeinsatz. In herkömmlichen Sensoranordnungen kann die Zuverlässigkeit durch Dreckeinlagerung in derartigen Fugen beeinträchtigt werden. Dies kann durch die erfindungsgemäße Sensoranordnung verhindert werden.

Eine Anwendungsmöglichkeit, bei der insbesondere die Eigenschaft einer flachen Bauweise erforderlich ist, ist die Betriebskontrolle in Filteranlagen in der Getränkeindustrie. In solchen Filteranlagen kann es vorkommen, daß mehrere Filterstufen relativ eng benachbart gestaffelt angeordnet sind. Wenn in den geringen Zwischenräumen zwischen den Filterstufen Drucksensoren plaziert werden müssen, so sind dafür Sensoren mit geringer Bauhöhe und fugenloser Oberfläche erforderlich.

Die vorliegende Erfindung wird im folgenden unter Bezugnahme auf die begleitenden Zeichnungen detaillierter beschrieben werden.
Fig. 1 zeigt eine erste Ausführungsform der vorliegenden Erfindung, bei der das Trägersubstrat keine Strukturierung aufweist;
Fig. 2 zeigt eine zweite Ausführungsform der vorliegenden Erfindung, bei der das Trägersubstrat eine Strukturierung aufweist;
Fig. 3 zeigt eine dritte Ausführungsform der vorliegenden Erfindung, die sich auf ein Sensorelement mit einer Sensoranordnung und einem Trägerelement bezieht;
Fig. 4 zeigt eine weitere Ausführungsform der vorliegenden Erfindung.

Die vorliegende Erfindung wird vorzugsweise durch eine zweischichtige Sandwich-Anordnung von einem Chip und einem Trägersubstrat oder eine dreischichtige Sandwich-Anordnung mit einem Chip, einem Trägersubstrat und einem Montagekörper realisiert.

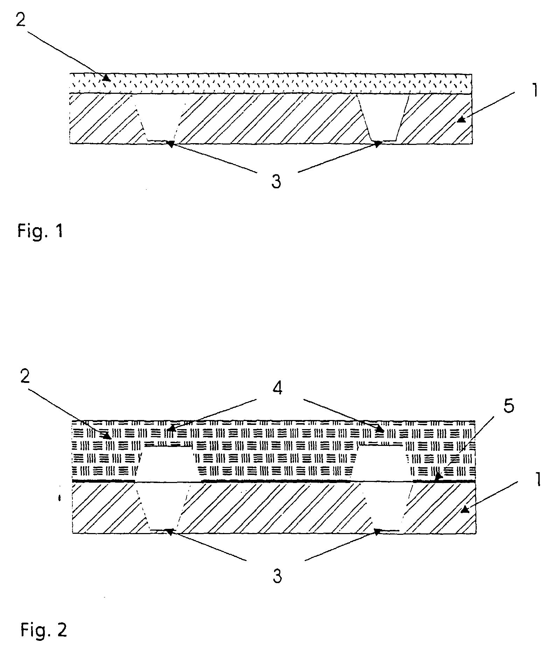

In Fig. 1 bezeichnet Bezugszeichen 1 einen Chip auf Siliziumbasis mit sensorischen Wandlergebieten und einer ersten Vorder- und einer ersten Rückseite, der auf seiner ersten Rückseite eine strukturierte Oberfläche mit Dünnungsgebieten 3 aufweist. Bezugszeichen 2 bezeichnet das Trägersubstrat, welches eine zweite Vorder- und eine zweite Rückseite aufweist. Chip und Trägersubstrat sind dabei dergestalt zusammengefügt, daß die erste und die zweite Rückseite aneinandergrenzen. Bei der in Fig. 1 gezeigten Ausführungsform der vorliegenden Erfindung ist die Rückseite des Trägersubstrats 2 nicht strukturiert, weist also über den gesamten Zusammenfügungsbereich mit dem Chip 1 eine weitgehend gleichmäßige geringe Dicke auf. Diese Dicke ist vorzugsweise so zu bemessen, daß ein genügend großer Anteil der physikalischen Meßgröße in den Chip 1 übertragen wird, so daß sich sinnvoll weiterverarbeitbare elektrische Signale ergeben.

In Fig. 2 hingegen ist auch die Rückseite des Trägersubstrats 2 strukturiert und weist Dünnungsgebiete 4 auf.

Dabei sind Chip und Trägersubstrat in beiden Ausführungsformen in ihren wesentlichen Grundgeometrien vorzugsweise spiegelbildlich gestaltet. Zu dieser Spiegelsymmetrie gehört, daß Chip und Trägersubstrat im wesentlichen identische Außenabmessungen haben, und daß - im Fall der zweiten Ausführungsform - die jeweiligen Dünnungsgebiete spiegelbildlich paßkonform sind.

Die Paßkonformität bedeutet dabei nicht, daß exakt die gleichen Abmessungen, beispielsweise des Versteifungsgebiets der Dünnungszone (vielfach auch Membrangebiet genannt) zwingend sind. Für die vorliegende Erfindung ist vielmehr wichtig, daß jeweils Chip und Trägersubstrat an den Bereichen außer den Dünnungsgebieten lückenlos aneinandergrenzen oder fest miteinander verbunden werden können, so daß über die lückenlos aneinandergrenzenden oder festen Verbindungsbereiche 2a, 2b eine wohldefinierte Krafteinkopplung von Chip auf Trägersubstrat erfolgt. Die feste Verbindungsschicht zwischen Chip und Trägersubstrat besteht dabei vorzugsweise aus einem Klebstoff-, Polyimid- oder Pyrex-Material, und die Verbindung erfolgt vorzugsweise durch Kleben, Waferkleben oder Waferbonden, beispielsweise anodisches oder Polyimid-Waferbonden.

Ebenso können die Dicken der Dünnungsgebiete (Membrandicken) des Chips anders als die des Trägersubstrats ausgebildet sein.

Vorzugsweise enthält die erste Rückseite des Chips 1 im Querschnitt senkrecht zur Sensoroberfläche mehrere Dünnungsgebiete 3, welche vorzugsweise konzentrisch angeordnet um das Versteifungsgebiet oder den festen Verbindungsbereich 2b umlaufen. Vorzugsweise ist das mindestens eine Dünnungsgebiet 3 ringförmig ausgebildet und derart positioniert, daß die Sensoranordnung im Querschnitt senkrecht zur Sensoroberfläche symmetrisch zur zur Sensoroberfläche senkrechten Mittelpunktsachse ausgebildet ist. Weiterhin ist ein quadratischer Konturverlauf der Dünnungsgebiete bevorzugt.

Bevorzugte Trägersubstratmaterialien umfassen Pyrex, Silizium, Glas, Keramik oder Stahl.

Die zweite Oberfläche des Trägersubstrats weist im Fall einer wafermäßigen Bearbeitung für den Fügevorgang von Chip 1 und Trägersubstrat 2 vorzugsweise eine Oberflächenschicht aus Siliziumnitrid, Siliziumcarbid oder einem Oxidmaterial auf. Ferner ist bevorzugt, daß die erste Oberfläche des Chips Anschluß- und Verbindungsbereiche für die Kontaktierung von Wandlergebieten mit elektrischen bzw. elektronischen Komponenten außerhalb des Chips aufweist.

Die Strukturierung der Dünnungsgebiete erfolgt vorzugsweise mit Verfahren der Mikromechanik nach bekanntem Stand der Technik. Bevorzugte Ätztechniken umfassen dabei KOH-Ätztechnologie, Trench-Tiefätztechnologie oder Ätztechnologie von porösem Silizium.

Ein wirtschaftlicher Vorteil ergibt sich beispielsweise insbesondere dann, wenn beispielsweise der in der Herstellung teurere Chip unverändert und damit kostengünstig für mehrere Sensoren des gleichen Typs aber unterschiedliche Lastbereiche eingesetzt werden kann und die applikationsspezifische Anpassung auf die Lastbereiche durch Variation beispielsweise der Membrandicke des billiger herzustellenden Trägersubstrats durchführbar ist. Als Freiheitsgrad für die Anpassungsdimensionierungen ist die genannte zulässige unterschiedliche Detailgeometrie des Chips und des Trägersubstrats von Vorteil. Entsprechend kann beispielsweise bei der mikromechanischen Strukturierung von Chip und Trägersubstrat der Chip immer in gleicher Weise gefertigt werden, während die Maske für das Trägersubstrat variiert wird.

Bei der erfindungsgemäßen Sensoranordnung können verschiedene Wandlungsprinzipien implementiert werden, beispielsweise das piezoresistive oder das kapazitive.

In den gezeigten Figuren bezeichnet Bezugszeichen 11 einen eingeschlossenen Mikrostrukturierungskammerbereich. Damit nicht beispielsweise neben dem eigentlich zu messenden Druck eine störende Absolutdruckkomponente auftritt, kann der Chip 1 zum Ausgleich von Umgebungsdruck und Druck im eingeschlossenen Mikrostrukturierungskammerbereich 11 eine Strukturierung von der ersten Oberfläche her erhalten, so daß eine Öffnung zum Mikrostrukturierungskammerbereich 11 erzielt wird.

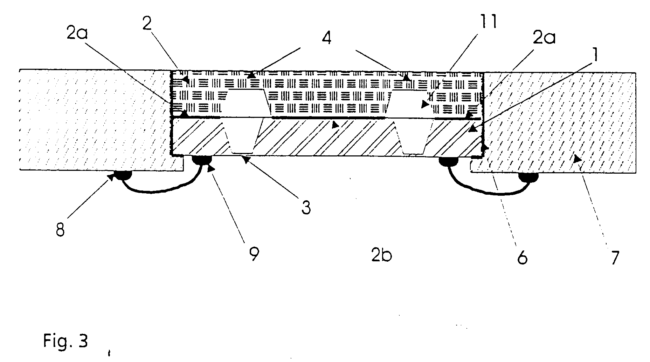

Fig. 3 zeigt eine dritte Ausführungsform der vorliegenden Erfindung, die sich auf ein Sensorelement bezieht. In Fig. 3 bezeichnen dieselben Bezugszeichen dieselben Komponenten wie in den Fig. 1 und 2. Außerdem bezeichnet Bezugszeichen 7 einen Montagekörper, in den die in den Fig. 1 und 2 gezeigte Sensoranordnung weitgehend oberflächenbündig eingesetzt ist. 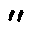 Weitgehend oberflächenbündig" heißt dabei, daß die zweite Vorderseite des Trägersubstrats möglichst fugen- und absatzlos, d.h. fugen- und absatzlos bis auf herstellungsbedingte Abweichungen, an den Montagekörper anschließt. Dazu ist es vorteilhaft, wenn die Aussparung im Montagekörper 7 paßgenau zur Geometrie der Sensoranordnung ausgelegt ist. Bezugszeichen 6 bezeichnet einen Montagespalt zwischen Sensoranordnung und Montagekörper. Der Montagekörper kann dabei beispielsweise aus einer Keramik oder Glas aufgebaut sein.

In Fig. 3 bezeichnet Bezugszeichen 8 darüber hinaus eine trägerseitige elektrische Verbindung, während Bezugszeichen 9 eine chipseitige elektrische Verbindung bezeichnet. Gemäß der vorliegenden Erfindung ist eine elektrische Kontaktierung der Wandlergebiete bzw. der Chippads, zu denen auf dem Chip eine Verdrahtung mit den Wandlergebieten führt, mit bekannten Standardverfahren möglich.

Neben einer Bondverbindung kann die Verbindung zwischen Chippads und Leiterbahnen auf dem Montagekörper auch durch Flip-Chip-Montage realisiert werden.

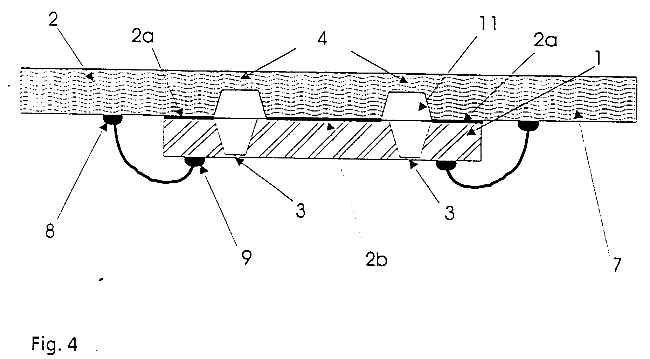

Gemäß einer weiteren Ausführungsform kann der Montagekörper 7 auch einstückig das in den Fig. 1 bis 3 mit Trägersubstrat 2 bezeichnete Element beinhalten, wie auch in Fig. 4 gezeigt ist. Der Chip 1 steht dann mit dem in diesem Fall nicht einzelkörperlichen aber funktional vorhandenen Gebiet 2a und 2b in Verbindung. Alternativ kann der Montagekörper auch mit dem Trägersubstrat 2 einstückig ausgebildet sein. Dadurch kann jeweils ein Sensorelement realisiert werden, das gänzlich fugenlos ist. Dies kann realisiert werden, wenn beispielsweise ein Keramikteil, das die Wandung eines Druckbehälters darstellt, eine Stelle aufweist, die dem bisher beschriebenen Trägersubstrat entspricht. In einem solchen Fall lassen sich die Dünnungsgebiete beispielsweise durch Schleifen oder durch Gieß- oder evtl. Sinterverfahren geeignet erzeugen. Nachteilig ist bei diesen Ausführungsformen jedoch, daß die Verbindung von Trägersubstrat 2 und Chip 1 nicht mehr durch Full-Wafer-Verbindungstechniken erfolgen kann.

Die soeben diskutierten Ausführungsformen lassen sich beispielsweise unter Verwendung von Stahl als Trägersubstrat und Montagekörper realisieren. Stahl ist neben Keramik in der Lebensmittelbranche durchaus beliebt. In diesem Fall müßte selbstverständlich die elektrische Isolationsnotwendigkeit, beispielsweise durch das Material der Verbindungsschicht berücksichtigt werden. Technisch beinhaltet die Verwendung von Stahl Probleme in Hinblick auf die unterschiedlichen Ausdehnungskoeffizienten von Stahl und Silizium. Es gibt zwar Stähle (Kovar), die einerseits im Temperaturausdehnungskoeffizient optimiert sind, andererseits aber schwer bearbeitbar und teuer sind.

Zum Wirkungsverfahren der erfindungsgemäßen Sensoranordnung bzw. des erfindungsgemäßen Sensorelements sei noch folgendes angemerkt. Die erfindungsgemäße Sandwich-Anordnung beispielsweise aus Chip und Trägersubstrat kann als eine mikromechanische Parallelogramm-Struktur betrachtet werden. Bei einer Ausführungsform der Sensoranordnung zur Messung von Kraft kann durch nichtideale Krafteinkopplung, die in der Praxis beispielsweise aufgrund von Fertigungstoleranzen oder thermisch bedingten Veränderungen in der Gesamtmeßanordnung auftreten kann, eine Kraftzerlegung in eine gedanklich senkrecht auf der Sandwich-Oberfläche stehende Wirkkomponente und in eine parallel zur Oberfläche verlaufende Störkomponente auftreten. Dabei kann die Störkomponente zumindest teilweise durch die Abstützung des Dünnungsgebiets am Rand des Trägersubstrats 2 erfolgen, wobei dieser Störkomponentenanteil dann nicht mehr fehlerinduzierend in den sensorischen Chip 1 gelangt.

Bei der Dimensionierung der einzelnen Komponenten ist ferner zu beachten, daß der Signalhub beispielsweise beim piezoresistiven Wandlerprinzip vom mechanischen Streß der Wandlergebiete abhängt. Folglich ist zu berücksichtigen, daß bei entsprechend steifer Auslegung des Trägersubstrats evtl. ein geringerer Signalhub im Chip resultieren kann, der beispielsweise durch einen größeren Verstärkungsfaktor in einem Signalverarbeitungsteil der Sensoreinrichtung ausgeglichen werden müßte.

## Patentansprüche

1. Sensoranordnung zur Messung von Druck, Kraft oder Meßgrößen, die sich auf Druck oder Kraft zurückführen lassen, mit
- einem Chip (1) auf Si-Basis mit mindestens einem sensorischen Wandlergebiet und einer ersten Vorder- und einer ersten Rückseite, der auf mindestens der ersten Rückseite eine strukturierte Oberfläche mit mindestens einem Dünnungsgebiet (3), das umlaufend ein Versteifungsgebiet umschließt, aufweist, wobei die strukturierte Oberfläche auf der ersten Rückseite eine intensivere Tiefenprofilierung als die erste Vorderseite aufweist,
- einem Trägersubstrat (2) mit einer zweiten Vorder- und einer zweiten Rückseite, wobei die zweite Vorderseite glatt und weitgehend fugenlos ist und der Chip und das Trägersubstrat dergestalt zusammengefügt sind, daß die erste und die zweite Rückseite aneinandergrenzen,
**dadurch gekennzeichnet, daß** die Sensoranordnung geeignet ist, eine Einleitung der Meßgröße auf die zweite Vorderseite zuzulassen, das mindestens eine Dünnungsgebiet (3) der ersten Rückseite eine vorbestimmte Dünnungstiefe aufweist und die erste und zweite Rückseite in allen Teilgebieten der Sensoranordnung außer den Bereichen der Dünnungsgebiete lückenlos aneinandergrenzen oder feste Verbindungsbereiche (2a, 2b) aufweisen.

2. Sensoranordnung nach Anspruch 1, **dadurch gekennzeichnet, daß** die erste Rückseite des Chip im Querschnitt senkrecht zur Sensoroberfläche mehrere Dünnungsgebiete (3) aufweist, welche vorzugsweise konzentrisch angeordnet um das Versteifungsgebiet oder den festen Verbindungsbereich (2b) umlaufen.

3. Sensoranordnung nach einem der vorhergehenden Ansprüche, **dadurch gekennzeichnet, daß** Chip (1) und Trägersubstrat (2) weitgehend identische Abmessungen haben.

4. Sensoranordnung nach einem der vorhergehenden Ansprüche, **dadurch gekennzeichnet, daß** die Dünnungsgebiete (3) ringförmig ausgebildet sind.

5. Sensoranordnung nach einem der vorhergehenden Ansprüche, welche im Querschnitt senkrecht zur Sensoroberfläche symmetrisch zur zur Sensoroberfläche senkrechten Mittelpunktsachse ausgebildet ist.

6. Sensoranordnung nach einem der vorhergehenden Ansprüche, **dadurch gekennzeichnet, daß** die zweite Rückseite des Trägersubstrats (2) eine strukturierte Oberfläche mit Dünnungsgebieten (4) aufweist.

7. Sensoranordnung nach Anspruch 6, **dadurch gekennzeichnet, daß** die Dünnungsgebiete (3) des Chips (1) spiegelbildlich zu dem Trägersubstrat (2) in ihrer Grundgeometrie aufeinander abgestimmt sind.

8. Sensorapordnung nach einem der vorhergehenden Ansprüche, **dadurch gekennzeichnet, daß** die Strukturierung der Oberflächen durch KOH-Ätztechnologie, Trench-Tiefätztechnologie oder durch Ätztechnologie von porösem Silizium erfolgt ist.

9. Sensoranordnung nach einem der vorhergehenden Ansprüche, **dadurch gekennzeichnet, daß** die Verbindungsschicht (5) zwischen Chip und Trägersubstrat aus einem Klebstoff-, Polyimid- oder Pyrex-Material besteht und die Verbindung durch Kleben, Waferkleben oder Waferbonden hergestellt ist.

10. Sensoranordnung nach einem der vorhergehenden Ansprüche, **dadurch gekennzeichnet, daß** der Chip (1) in der ersten Oberfläche eine derartige Strukturierung aufweist, daß zum Druckausgleich zwischen dem eingegrenzten Kammervolumen zwischen Chip (1) und Trägersubstrat (2) und dem Umgebungsdruck seitens der ersten Oberfläche eine offene Verbindung vorliegt.

11. Sensoranordnung nach einem der vorhergehenden Ansprüche, **dadurch gekennzeichnet, daß** die zweite Vorderseite des Trägersubstrats (2) eine Oberflächenschicht aus Siliziumnitrid, Siliziumcarbid oder einem Oxidmaterial aufweist.

12. Sensoranordnung nach einem der vorhergehenden Ansprüche, **dadurch gekennzeichnet, daß** die erste Vorderseite des Chips (1) Anschluß- und Verbindungsbereiche für die Kontaktierung von Wandlergebieten mit elektrischen bzw. elektronischen Komponenten außerhalb des Chips (1) aufweist.

13. Sensoranordnung nach einem der vorhergehenden Ansprüche, **dadurch gekennzeichnet, daß** das Wandlungsprinzip der sensorischen Wandlergebiete kapazitiv ist.

14. Sensoranordnung nach einem der Ansprüche 1 bis 12, **dadurch gekennzeichnet, daß** das Wandlungsprinzip der sensorischen Wandlergebiete piezoresistiv ist.

15. Sensoranordnung nach einem der vorhergehenden Ansprüche, **dadurch gekennzeichnet, daß** das Material des Trägersubstrats (2) Silizium, Pyrex, Glas, Keramik oder Stahl ist.

16. Sensorelement mit einer Sensoranordnung nach einem der vorhergehenden Ansprüche und einem Montagekörper (7), in den die Sensoranordnung weitgehend oberflächenbündig eingesetzt ist.

17. Sensorelement nach Anspruch 16, **dadurch gekennzeichnet, daß** der Montagekörper (7) eine Keramik umfaßt.

18. Sensorelement nach Anspruch 16 oder 17**, dadurch gekennzeichnet, daß** der Montagekörper (7) und der Chip (1) einstückig ausgebildet sind.

19. Sensorelement nach Anspruch 16 oder 17, **dadurch gekennzeichnet, daß** der Montagekörper (7) und das Trägersubstrat (2) einstückig ausgebildet sind.

20. Verfahren zur Herstellung einer Sensoranordnung zur Messung von Druck, Kraft oder Meßgrößen, die sich auf Druck oder Kraft zurückführen lassen, mit den Schritten zum
- Bereitstellen eines Chips (1) auf Si-Basis mit mindestens einem sensorischen Wandlergebiet und einer ersten Vorder- und einer ersten Rückseite,
- mikromechanischen Strukturieren von mindestens der ersten Rückseite, so daß mindestens ein Dünnungsgebiet (3), das umlaufend ein Versteifungsgebiet umschließt, erzeugt wird, wobei die Strukturierung derart erfolgt, daß die strukturierte Oberfläche auf der ersten Rückseite eine intensivere Tiefenprofilierung als die erste Vorderseite aufweist,
- Bereitstellen eines Trägersubstrats (2) mit einer zweiten Vorder- und einer zweiten Rückseite, bei dem die zweite Vorderseite glatt und weitgehend fugenlos ist, und
- Zusammenfügen des Chips (1) und des Trägersubstrats (2) dergestalt, daß die erste und die zweite Rückseite aneinandergrenzen,
**dadurch gekennzeichnet, daß** das mindestens eine Dünnungsgebiet (3) der ersten Rückseite eine vorbestimmte Dünnungstiefe aufweist und die erste und zweite Rückseite in allen Teilgebieten der Sensoranordnung außer den Bereichen der Dünnungsgebiete lückenlos aneinandergrenzen oder feste Verbindungsbereiche (2a, 2b) aufweisen.

21. Verfahren nach Anspruch 20, **dadurch gekennzeichnet, daß** die erste Rückseite des Chip im Querschnitt senkrecht zur Sensoroberfläche mehrere Dünnungsgebiete (3) aufweist, welche vorzugsweise konzentrisch angeordnet um das Versteifungsgebiet oder den festen Verbindungsbereich (2b) umlaufen.

22. Verfahren nach Anspruch 20 oder 21, **dadurch gekennzeichnet, daß** Chip (1) und Trägersubstrat (2) weitgehend identische Abmessungen haben.

23. Verfahren nach einem der Ansprüche 20 bis 22, **dadurch gekennzeichnet, daß** die Dünnungsgebiete (3) ringförmig ausgebildet werden.

24. Verfahren nach einem der Ansprüche 20 bis 23, **dadurch gekennzeichnet, daß** die Sensoranordnung im Querschnitt senkrecht zur Sensoroberfläche symmetrisch zur zur Sensoroberfläche senkrechten Mittelpunktsachse ausgebildet wird.

25. Verfahren nach einem der Ansprüche 20 bis 24, **gekennzeichnet durch den schritt zum** Strukturieren der zweiten Rückseite des Trägersubstrats (2), so daß diese eine strukturierte Oberfläche mit Dünnungsgebieten (4) aufweist.

26. Verfahren nach Anspruch 25, **dadurch gekennzeichnet, daß** die Dünnungsgebiete (3) des Chips (1) spiegelbildlich zu dem Trägersubstrat (2) in ihrer Grundgeometrie aufeinander abgestimmt werden.

27. Verfahren nach einem der Ansprüche 20 bis 26, **dadurch gekennzeichnet, daß** die Strukturierung der Oberflächen durch KOH-Ätztechnologie, Trench-Tiefätztechnologie oder durch Ätztechnologie von porösem Silizium erfolgt.

28. Verfahren nach einem der Ansprüche 20 bis 27, **dadurch gekennzeichnet, daß** die Verbindungsschicht zwischen Chip (1) und Trägersubstrat (2) aus einem Klebstoff-, Polyimid- oder Pyrex-Material besteht und die Verbindung durch Kleben, Waferkleben oder Waferbonden hergestellt wird.

29. Verfahren nach einem der Ansprüche 20 bis 28, **dadurch gekennzeichnet, daß** die Strukturierung der ersten Oberfläche des Chips (1) derartig erfolgt, daß zum Druckausgleich zwischen dem eingegrenzten Kammervolumen zwischen Chip (1) und Trägersubstrat (2) und dem Umgebungsdruck seitens der ersten Oberfläche eine offene Verbindung vorliegt.

30. Verfahren nach einem der Ansprüche 20 bis 29, **dadurch gekennzeichnet, daß** die zweite Vorderseite des Trägersubstrats (2) eine Oberflächenschicht aus Siliziumnitrid, Siliziumcarbid oder einem Oxidmaterial aufweist.

31. Verfahren nach einem der Ansprüche 20 bis 30, **gekennzeichnet durch** den Schritt zum Bereitstellen von Anschluß- und Verbindungsbereichen für die Kontaktierung von Wandlergebieten mit elektrischen bzw. elektronischen Komponenten außerhalb des Chips (1) auf der ersten Vorderseite des Chips (1).

32. Verfahren nach einem der Ansprüche 20 bis 31, **dadurch gekennzeichnet, daß** das Wandlungsprinzip der sensorischen Wandlergebiete kapazitiv ist.

33. Verfahren nach einem der Ansprüche 20 bis 31, **dadurch gekennzeichnet, daß** das Wandlungsprinzip der sensorischen Wandlergebiete piezoresistiv ist.

34. Verfahren nach einem der Ansprüche 20 bis 33, **dadurch gekennzeichnet, daß** das Material des Trägersubstrats Pyrex, Silizium, Glas, Keramik oder Stahl ist.

35. Verfahren nach einem der Ansprüche 20 bis 34, **dadurch gekennzeichnet, daß** das Verbinden von Chip (1) und Trägersubstrat (2) mit einer Full-Wafer-Verbindungstechnik erfolgt.

36. Verfahren zur Herstellung eines Sensorelements, gekennzeichnet durch die Schritte zum
- Bereitstellen eines Sensoranordnung nach einem der Ansprüche 1 bis 15 und
- weitgehend oberflächenbündiges Einsetzen der Sensoranordnung in einen Montagekörper(7).

37. Verfahren nach Anspruch 36, **dadurch gekennzeichnet, daß** der Montagekörper (7) eine Keramik umfaßt.

38. Verfahren nach Anspruch 36 oder 37, **dadurch gekennzeichnet, daß** die elektrische Verbindung der Sensoranordnung mit dem Montagekörper (7) durch Flip-Chip-Montage erfolgt.

39. Verfahren nach einem der Ansprüche 36 bis 38, **dadurch gekennzeichnet, daß** der Montagekörper (7) und der Chip (1) einstückig ausgebildet sind.

40. Verfahren nach einem der Ansprüche 36 bis 38, **dadurch gekennzeichnet, daß** der Montagekörper (7) und das Trägersubstrat (2) einstückig ausgebildet sind.

41. Verwendung der Sensoranordnung nach einem der Ansprüche 1 bis 15 oder des Sensorelements nach einem der Ansprüche 16 bis 19 in einer Getränkeherstellungs- oder -Abfüllanlage.
